# EUROPÄISCHE PATENTSCHRIFT

(11) **EP 2 777 083 B1**
(45) Veröffentlichungstag und Bekanntmachung des Hinweises auf die Patenterteilung: **20.01.2016**
(21) Anmeldenummer: 13720962.3
(22) Anmeldetag: 08.05.2013
(51) Int. Cl.: H01L 41/29

(54) **VERFAHREN ZUM ELEKTRISCHEN KONTAKTIEREN EINES ELEKTRONISCHEN BAUELEMENTS ALS STAPEL UND ELEKTRONISCHES BAUELEMENT MIT EINER KONTAKTIERUNGSSTRUKTUR**
METHOD FOR MAKING ELECTRICAL CONTACT WITH AN ELECTRONIC COMPONENT IN THE FORM OF A STACK, AND ELECTRONIC COMPONENT HAVING A CONTACT-MAKING STRUCTURE
PROCÉDÉ DE MISE EN CONTACT ELECTRIQUE D'UN MODULE ÉLECTRONIQUE SOUS FORME D'EMPILEMENT ET MODULE ÉLECTRONIQUE A STRUCTURE DE CONTACT

(30) Priorität: 08.05.2012 DE 102012207598
(43) Veröffentlichungstag der Anmeldung: 17.09.2014
(73) Patentinhaber: Continental Automotive GmbH, 30165 Hannover (DE)
(72) Erfinder: RICHTER, Thomas, 93049 Regensburg (DE); LENK, Andreas, 01728 Bannewitz Ot Possendorf (DE); ZUMSTRULL, Claus, 93128 Regenstauf (DE)
(86) Internationale Anmeldenummer: PCT/EP2013/059562
(87) Internationale Veröffentlichungsnummer: WO 2013/167643

(56) Entgegenhaltungen:
- DE-A1-102006 049 323
- DE-A1-102008 049 788
- DE-A1-102010 022 911
- GB-A- 2 258 084
- JP-A- H 053 352
- JP-A- 2005 079 313

## Beschreibung

Die Erfindung betrifft ein Verfahren zum elektrischen Kontaktieren eines elektronischen Bauelements als Stapel, das aus einer Mehrzahl von auf Anlegen eines elektrischen Feldes reagierenden Werkstoffschichten und einer Anzahl von Elektrodenschichten gebildet ist, wobei jede Werkstoffschicht zwischen zwei der Elektrodenschichten angeordnet ist, gemäß dem Oberbegriff des Patentanspruches 1. Die Erfindung betrifft ferner ein als Stapel ausgebildetes elektronisches Bauelement der oben genannten Art gemäß dem Oberbegriff des Patentanspruches 9.

Ein solches Bauelement aus übereinander und alternierend zueinander gestapelten Schichten von Werkstoffschicht und Elektrodenschicht wird allgemein als Stapel bezeichnet. Das heutzutage bekannteste elektronische Bauelement dieser Art ist ein allgemein als Piezoaktor bezeichneter Stapel, der als Betätigungselement in Einspritzventilen der verschiedensten Motortypen für Kraftfahrzeuge zur Anwendung kommt. Die Werkstoffschichten sind bei diesem Piezoaktor Keramikschichten.

Üblicherweise weist ein solcher Stapel, in der Draufsicht betrachtet, einen rechteckigen oder quadratischen Querschnitt auf. Der Stapel wird an zwei sich gegenüberliegenden Umfangsseiten elektrisch kontaktiert. Um dies technologisch sorgfältig durchführen zu können, wurden die Elektrodenschichten in der Vergangenheit geometrisch so ausgelegt, dass sich nur jede zweite Elektrodenschicht seitlich bis zu einer der beiden Umfangsseiten erstreckt, während sich die jeweils anderen Elektrodenschichten nicht bis zu dieser Umfangsseite hin erstrecken. Entsprechendes gilt für die andere Umfangsseite des Stapels analog.

Darüber hinaus sind sog. vollaktive Stapel bekannt, bei denen die Elektrodenschichten und die Werkstoffschichten die gleiche Fläche aufweisen, wodurch sich sämtliche Elektrodenschichten jeweils bis an die gegenüberliegenden Umfangsseiten erstrecken. Da sich sämtliche Elektrodenschichten des Bauelements bis zu den beiden gegenüberliegenden Umfangsseiten erstrecken, muss die Kontaktierung auf andere Weise erfolgen.

Aus der DE 101 53 770 A1 ist ein Verfahren zur Kontaktierung einer gestapelten piezoelektrischen Vorrichtung bekannt. Bei diesem Verfahren wird beidseitig abwechselnd jede zweite Elektrodenschicht mit einer elektrisch isolierenden Schicht versehen. Anschließend werden die freiliegenden Elektrodenschichten jeder Umfangsseite über eine leitende Schicht miteinander verbunden. Als leitende Schicht wird ein Harz verwendet, das leitfähige Partikel enthält.

Aus der DE 10 2006 003 070 B3 ist ein Verfahren zur elektrischen Kontaktierung eines als Stapel gebildeten Bauelements bekannt, welches aus Werkstoff schichten und Elektrodenschichten besteht. Zur Ankontaktierung wird auf zwei gegenüberliegenden Seiten eine Isolationsschicht aufgebracht. Anschließend wird jede Isolationsfolie durch Laserstrukturierung an der Position jeder zweiten Elektrodenschicht geöffnet. Anschließend werden die Elektrodenschichten auf jeder Umfangsseite mit einem elektrisch leitenden Material miteinander verbunden.

Allgemein sind aufgrund gegebener Anforderungen eine hohe Temperaturbeständigkeit des Aktors sowie eine hohe Dauerhaltbarkeit gefordert. Wesentlich hierfür ist eine gute Anbindung von Außenelektroden an die sehr dünnen Elektrodenschichten des Stapels. Ist die elektrische Anbindung der Außenelektroden an die Elektrodenschichten nicht niederohmig oder fehlerstellenbehaftet, kann es lokal zu überhöhten Stromdichten und damit erhöhten Temperaturen kommen, welche im schlechtesten Fall zu einer dauerhaften Dekontaktierung führen können. Diese Problematik ist insbesondere dann gegeben, wenn das Material der Außenelektroden, welche auf den gegenüberliegenden Umfangsseiten die Elektrodenschichten elektrisch kontaktieren, aus einem Leitkleber gebildet ist. Ein Leitkleber umfasst elektrisch leitende Partikel, beispielsweise aus Silber, Gold oder einem beliebigen anderen Metall oder einer Metalllegierung, welche in ein isolierendes Trägermaterial, z.B. ein Polyimidharz, ein Epoxidharz, usw., eingebettet sind.

DE 10 2010 022 911 beschreibt ein Verfahren zum Herstellen eines Piezoaktors mit einem Piezostapel und zwei an der Außenseite des Piezostapels angeordneten Außenelektroden. Das erfindungsgemäße Verfahren umfasst die folgenden Schritte: Bereitstellen eines vollaktiven Grünstapels aus mehreren abwechselnd aufeinander folgenden Grünfolien und durchgehenden Innenelektrodenschichten, die dazu vorgesehen sind, abwechselnd mit zwei an der Außenseite des aus dem Grünstapel herzustellenden Piezostapels anzuordnenden Außenelektroden elektrisch verbunden und von der jeweiligen anderen Außenelektrode elektrisch isoliert zu sein; Versehen der Außenseite des vollaktiven Grünstapels mit Gräben in Bereichen, in denen die Innenelektrodenschichten von den entsprechenden Außenelektroden elektrisch isoliert sein sollen, so dass die Gräben die Innenelektrodenschichten in diesen Bereichen von der Außenseite des Grünstapels nach innen verkürzen; Füllen der Gräben mit einem elektrisch isolierenden Schlicker; Weiterverarbeiten des Grünstapels, dessen Gräben mit dem Schlicker gefüllt sind, so dass aus den Grünfolien piezoelektrische Schichten werden und aus dem Grünstapel der Piezostapel wird; Aufbringen der beiden Außenelektroden auf die Außenseite des Piezostapels, so dass die beiden Außenelektroden abwechselnd mit den Innenelektrodenschichten elektrisch verbunden sind. Das erfindungsgemäße Verfahren zeichnet sich dadurch aus, dass die Gräben mit dem Schlicker durch eines der folgenden Verfahren gefüllt werden: Siebdrucken, Tauchen, Sprühen oder Vakuuminfiltrieren.

DE 10 2008 049 788 A1 betrifft einen Ultraschallwandler mit mindestens einem monolithischen, stapelförmigen Piezoelement, das in Stapelrichtung eine Elektrodenschicht, mindestens eine weitere Elektrodenschicht und mindestens eine zwischen den Elektrodenschichten angeordnete Piezokeramikschicht aufweist, wobei sich die Elektrodenschicht bis an einen seitlichen Oberflächenabschnitt des Piezoelements erstreckt und eine Außenelektrode derart am Oberflächenabschnitt des Piezoelements angeordnet ist, dass die Außenelektrode am Oberflächenabschnitt selektiv mit der Elektrodenschicht elektrisch leitend verbunden und am Oberflächenabschnitt selektiv von der weiteren Elektrodenschicht elektrisch isoliert ist. Der Ultraschallwandler ist dadurch gekennzeichnet, dass zur selektiven elektrischen Kontaktierung der Außeneleketrode und der Elektrodenschicht miteinander und zur selektiven elektrischen Isolierung der Außenelektrode und der weiteren Elektrodenschicht voneinander am Oberflächenabschnitt eine Ausnehmung des Piezoelements vorhanden ist, die mit elektrischem Isolations-Material befüllt ist. Durch das Isolations-Material in der Ausnehmung sind die weitere Elektrodenschicht und die Außenelektrode elektrisch voneinander isoliert. Zum Herstellen des Ultraschallwandlers wird Elektrodenmaterial einer Innenelektrode eines Keramik-Riegels abgetragen. Die dadurch resultierende Ausnehmung wird mit Isolations-Material befüllt. Der Keramik-Riegel wird in einzelne Piezoelemente zerteilt.

GB 2 258 084 A offenbart einen laminierten elektromechanischen Wandler, der eine Vielzahl von inneren Elektroden aufweist, wobei jede zweite der Elektroden elektrisch kontaktiert ist und die anderen Elektroden elektrisch isoliert sind, indem zunächst elektromechanisches Wandlermaterial und die jeweilige Elektrode abgetragen werden und dann der entstehende Graben mit Isoliermaterial verfüllt wird.

In DE 10 2006 049 323 A1 ist ein piezoelektrisches Mehrschicht-Bauelement mit einem Körper angegeben, in dem Piezoschichten und Innenelektroden abwechselnd angeordnet sind, wobei mindestens eine Kante der jeweiligen Innenelektrode in eine an der Oberfläche des Körpers ausgebildete Vertiefung mündet, die sich entlang dieser Kante erstreckt.

In JP 05 003 352 A ist ein laminierter Piezoaktor beschrieben, bei dem jede zweite Schicht aus Piezokeramik und innerer Elektrode zurückgesetzt sind und der dadurch entstehende Graben mit einem isolierenden Material verfüllt ist.

JP 2005 079313 A beschreibt einen laminierten Piezoaktor, bei dem Keramikschichten oberflächlich derart abgetragen werden, dass Elektroden in einen dadurch gebildeten Graben hervorstehen, wobei die Keramikschichten als Ergebnis des Abtragungsverfahrens zwischen zwei benachbarten Elektroden eine konvexe Form aufweisen.

Es ist daher Aufgabe der vorliegenden Erfindung, ein Verfahren zum elektrischen Kontaktieren eines elektronischen Bauelements als Stapel sowie ein elektronisches Bauelement anzugeben, welche eine verbesserte Langzeit-Zuverlässigkeit des Stapels ermöglichen.

Diese Aufgaben werden gelöst durch ein Verfahren gemäß den Merkmalen des Patentanspruches 1 sowie ein als Stapel ausgebildetes elektronisches Bauelement gemäß den Merkmalen des Patentanspruchs 9. Vorteilhafte Ausgestaltungen ergeben sich jeweils aus den abhängigen Patentansprüchen.

Die Erfindung schafft ein Verfahren zum elektrischen Kontaktieren eines elektronischen Bauelements als Stapel, das aus einer Mehrzahl von auf Anlegen eines elektrischen Feldes reagierenden Werkstoffschichten und einer Mehrzahl von Elektrodenschichten gebildet ist, wobei jede Werkstoffschicht zwischen zwei der Elektrodenschichten angeordnet ist. Auf zumindest einem Stapelumfangsbereich des Stapels wird eine Isolationsstruktur erzeugt, so dass jede zweite Elektrodenschicht des zumindest einen Stapelumfangsbereichs zur elektrischen Kontaktierung freigelegt ist.

Bevorzugt wird dabei jede zweite, zu den frei gelegten Elektrodenschichten vorzugsweise alternierend angeordnete Elektrodenschicht zumindest teilweise von der Isolationsstruktur bedeckt.

Das Erzeugen der Isolationsstruktur und Freilegen jeder zweiten Elektrodenschicht von der Isolationsstruktur kann beispielsweise erfolgen, indem zunächst eine Isolationsschicht auf den Stapelumfangsbereich aufgetragen wird, von welcher anschließend zum Freilegen jeder zweiten Elektrodenschicht wieder Material entfernt wird. Alternativ kann die Isolationsstruktur auch über ein Direktstrukturierungsverfahren, z.B. mittels Sprühen oder Dispensen, aufgebracht werden, so dass jede zweite Elektrodenschicht frei bleibt.

Auf den zumindest einen, mit der Isolationsstruktur versehenen Stapelumfangsbereich wird dann eine Kontaktierungsstruktur aufgebracht. Vor dem Schritt des Erzeugens der Kontaktierungsstruktur wird mittels eines materialabtragenden Verfahrens lediglich das Material der Werkstoffschichten ohne Abtrag des Materials der Elektrodenschichten partiell derart abgetragen, dass die Elektrodenschichten oberflächennah freigelegt werden.

Vorzugsweise wird durch das partielle Abtragen der Werkstoffschichten zumindest jede zweite Elektrodenschicht oberflächennah freigelegt, insbesondere jede von der Isolationsstruktur freigelegte Elektrodenschicht.

Der Vorteil des erfindungsgemäßen Verfahrens besteht darin, dass durch das oberflächennahe Freilegen der Elektrodenschichten eine vergrößerte Fläche zur elektrischen Kontaktierung der Elektrodenschichten zur Verfügung steht. Hierdurch ist eine bessere elektrische Anbindung der Elektrodenschichten an die Kontaktierungsstruktur möglich. Die Gefahr von lokalen überhöhten Stromdichten und damit erhöhten Temperaturen kann hierdurch verringert werden. Im Ergebnis wird hierdurch die Langzeit-Zuverlässigkeit des hergestellten Stapels verbessert.

In einer zweckmäßigen Weiterbildung des erfindungsgemäßen Verfahrens erfolgt das Abtragen des Materials der Werkstoffschichten derart, dass oberflächennahe Abschnitte der Elektrodenschichten zusätzlich zu ihrer an den Stapelumfangsbereich grenzenden Stirnseite zumindest teilweise an ihren Hauptflächen freigelegt werden. Die elektrische Kontaktierung kann damit nicht nur an den Stirnflächen der Elektrodenschichten erfolgen, welche lediglich jeweils wenige Mikrometer breit sind. Stattdessen kann zusätzlich ein Kontaktierungsbereich an den jeweiligen Hauptflächen geschaffen werden. Die Größe des Kontaktierungsbereichs hängt dabei im Wesentlichen von dem gewählten materialabtragenden Verfahren und der Dauer der Materialabtragung ab.

Es sollte lediglich so viel Material der Werkstoffschichten abgetragen werden, dass eine erhöhte Kontaktfläche an den Elektrodenschichten geschaffen ist. Gleichzeitig darf die Stabilität der dünnen Elektrodenschichten durch das Abtragen der Materialschichten jedoch nicht geschwächt werden. Es ist ausreichend, wenn - ausgehend von einer durch die Stapelumfangsbereiche gebildeten Oberfläche - das Material der Werkstoffschichten wenige Mikrometer tief abgetragen wird. Insbesondere sollte das Abtragen des Materials der Werkstoffschichten eine Tiefe von 10 µm bis 20 µm nicht übersteigen. Bei größeren Tiefen besteht die Gefahr, dass die Elektrodenschichten und das Material der Werkstoffschichten, welches an die Elektroden grenzt, im weiteren Prozess der Weiterverarbeitung beschädigt werden könnten.

In einer weiteren zweckmäßigen Ausgestaltung erfolgt das partielle, oberflächennahe Abtragen des Materials der Werkstoffschichten vor dem Schritt des Erzeugens der Isolationsstruktur. Hierzu kann beispielsweise ein jeweiliger Stapelumfangsbereich (auf die die Außenelektroden aufgebracht werden) vor dem Erzeugen der Isolationsstruktur plan geschliffen werden, so dass die Elektrodenschichten an den Oberflächen der jeweiligen Stapelumfangsbereiche zunächst bündig mit den Werkstoffschichten abschließen. Anschließend erfolgt das oberflächennahe partielle Abtragen des Materials der Werkstoffschichten, um die Elektrodenschichten ungefähr gleichförmig oberflächennah freizulegen.

Alternativ kann auch vorgesehen sein, dass das partielle, oberflächennahe Abtragen des Materials der Werkstoffschichten nach dem Schritt des Erzeugens der Isolationsstruktur erfolgt. Insbesondere können das Freilegen jeder zweiten Elektrodenschicht und das Abtragen des Materials der Werkstoffschichten durch das gleiche Bearbeitungsverfahren erfolgen. Ein Vorteil dieser Vorgehensweise besteht darin, dass keine zusätzlichen Werkzeuge oder Bearbeitungsschritte im Rahmen der Herstellung des Bauelementstapels bereitgestellt werden müssen. Das gleichzeitige Freilegen jeder zweiten Elektrodenschicht des zumindest einen Stapelumfangsbereichs zur elektrischen Kontaktierung und das Abtragen des Materials der Werkstoffschichten in den freigelegten Bereichen kann beispielsweise unter Verwendung eines Lasers geschehen.

Das partielle, oberflächennahe Abtragen des Materials der Werkstoffschichten kann beispielsweise mittels Schleifen, Bürsten, Strahlen oder den Laser erfolgen. Das Strahlen kann beispielsweise mittels in einen Trägerstrom eingebrachte Partikel (z.B. Sand) erfolgen. Durch die genannten Bearbeitungsverfahren kann sichergestellt werden, dass lediglich das Material der Werkstoffschichten, jedoch nicht das Material der Elektrodenschichten während des Bearbeitungsvorganges abgetragen wird. Ebenso sind diese Verfahren geeignet, das Material der auf die Stapelumfangsbereiche aufgebrachten Isolationsschicht zum Freilegen jeder zweiten Elektrodenschicht zu entfernen.

In einer weiteren Ausgestaltung wird nach dem Schritt des Erzeugens der Isolationsstruktur und dem gegebenenfalls darauffolgenden Schritt des partiellen Abtragens des Materials der Werkstoffschicht eine dünne Metallschicht, insbesondere durch Sputtern, auf den Stapelumfangsbereich aufgebracht, auf welche in einem nachfolgenden Schritt die Kontaktierungsstruktur auf die dünne Metallschicht aufgebracht wird. Die dünne Metallschicht ermöglicht eine zuverlässigere und fehlstellenfreie Kontaktierung der Elektrodenschichten des Stapels. Wird die Kontaktierungsstruktur, wie dies bevorzugt ist, mittels eines Leitklebers realisiert, so können die in dem Leitkleber enthaltenen Metallpartikel die dünne Metallschicht auch im Bereich der Isolationsstruktur elektrisch kontaktieren und tragen damit zusätzlich zu einer Stromleitung bei. Auch hierdurch lässt sich die Zuverlässigkeit des elektronischen Bauelements erhöhen.

Die Erfindung schafft ferner ein als Stapel ausgebildetes elektronisches Bauelement. Dieses umfasst eine Mehrzahl von Elektrodenschichten und eine Mehrzahl von auf Anlegen eines elektrischen Feldes reagierenden Werkstoffschichten, wobei jede Werkstoffschicht zwischen zwei Elektrodenschichten angeordnet ist. Ferner ist eine Isolationsstruktur vorgesehen, die auf zumindest einem Stapelumfangsbereich des Stapels aufgebracht ist, wobei die Isolationsstruktur derart ausgebildet ist, dass jede zweite Elektrodenschicht eines Stapelumfangsbereichs zur elektrischen Kontaktierung freigelegt ist. Eine Kontaktierungsstruktur ist auf zumindest einen, mit der Isolationsstruktur versehenen Stapelumfangsbereich aufgebracht. Das als Stapel ausgebildete elektronische Bauelement zeichnet sich dadurch aus, dass die Werkstoffschichten in einem Schnitt, der parallel zu einer Längsachse des Stapels und senkrecht durch einen der Stapelumfangsbereiche verläuft, in einem oberflächennahen Bereich, der an die Elektrodenschichten angrenzt, zumindest teilweise derart abgetragen sind, dass die Elektrodenschichten sowohl an ihrer an den Stapelumfangsbereich grenzenden Stirnseite als auch zumindest teilweise an ihren sich gegenüberliegenden Hauptflächen freigelegt sind, und durch Material der Isolationsstruktur oder der Kontaktierungsstruktur ersetzt sind.

Insbesondere können vorzugsweise die Werkstoffschichten in einem oberflächennahen Bereich, der an die freigelegten Elektrodenschichten angrenzt, zumindest teilweise abgetragen und durch Material der Kontaktierungsstruktur ersetzt sein. Somit ist vorteilhaft jede zweite Elektrodenschicht mit der Kontaktierungsstruktur verbunden.

Unter dem oberflächennahen Bereich des Stapels ist hierbei eine Ebene bzw. Oberfläche des Stapelumfangsbereichs zu verstehen, wenn die Isolationsstruktur und die Kontaktierungsstruktur noch nicht auf den Stapelumfangsbereich aufgebracht sind. Nach dem Aufbringen grenzen die Isolationsstruktur bzw. die Kontaktierungsstruktur an den oberflächennahen Bereich der Werkstoffschichten.

Der erfindungsgemäß ausgebildete Stapel weist die gleichen Vorteile auf, wie diese vorstehend in Verbindung mit dem erfindungsgemäßen Verfahren erläutert wurden.

Die Oberflächenform der durch Materialabtragung bearbeiteten Werkstoffschichten ist so ausgebildet, dass die Werkstoffschichten in einer Schnittansicht durch den Schnitt zwischen zwei benachbarten Elektrodenschichten eine konkave Gestalt aufweisen. Die konkave Gestalt ergibt sich aus dem für die Bearbeitung gewählten materialabtragenden Verfahren. Insbesondere sind die Werkstoffschichten gegenüber dem Stapelumfangsbereich bereichsweise um höchstens 10 µm bis 20 µm reduziert. Diese geringe Materialabtragung ermöglicht einerseits eine verbesserte Kontaktierung der freigelegten Abschnitte der Elektrodenschichten. Andererseits ist die Materialreduzierung derart gering, dass die Weiterverarbeitung des derart vorbereiteten Stapels keine Abänderung der Verfahrensschritte zum Aufbringen der Isolationsstruktur und der Kontaktierungsstruktur erfordert. Insbesondere kann aufgrund der geringen Materialabtragung auch sichergestellt werden, dass die Oberflächen eines fertiggestellten Stapels eben sind.

Zweckmäßigerweise umfasst das Material der Kontaktierungsstruktur einen Leitkleber mit einem Träger aus einem nicht-leitenden Material, insbesondere Polyimid, und darin eingebetteten Metallpartikeln. Ein Vorteil der Verwendung eines Leitklebers als Material für die Kontaktierungsstruktur besteht darin, dass das nichtleitende Trägermaterial des Leitklebers ähnliche Eigenschaften aufweist, wie das zur Erzeugung der Isolationsstruktur eingesetzte Material. Hierdurch kann eine hohe Langzeit-Zuverlässigkeit des Stapels begünstigt werden, da hohe Temperaturen nicht zu unterschiedlichen Ausdehnungen der Isolations- und der Kontaktierungsstruktur führen. Weiterhin ist durch die vergrößerte Kontaktierungsfläche der Elektrodenschichten die Gefahr fehlstellenbehafteter Kontaktstellen verringert.

Die Erfindung wird nachfolgend näher anhand von Ausführungsbeispielen in der Zeichnung beschrieben. Es zeigen:
- Fig. 1: eine schematische Querschnittsdarstellung eines bekannten Bauelements, auf dessen Stapel aus Werkstoffschichten und Elektrodenschichten eine Isolationsstruktur und eine Kontaktierungsstruktur aufgebracht ist,
- Fig. 2: eine schematische Querschnittsdarstellung eines Teils einer ersten Ausführungsform eines erfindungsgemäßen Bauelementstapels, bei dem die Werkstoffschichten partiell abgetragen sind,
- Fig. 3: eine schematische Querschnittsdarstellung eines Teils einer zweiten Ausführungsform eines erfindungsgemäßen Bauelementstapels, bei dem die Werkstoffschichten in einer alternativen Ausgestaltung partiell abgetragen sind, und
- Fig. 4: eine vergrößerte Darstellung der Materialabtragung im Bereich einer Elektrodenschicht eines Bauelementstapels.

Ausgangspunkt ist ein als Stapel 1 ausgebildetes elektronisches Bauelement. Der Stapel 1 ist aus einer Mehrzahl von auf Anlegen eines elektrischen Feldes reagierenden Werkstoffschichten 2 und einer Mehrzahl von Elektrodenschichten 3, 4 gebildet. Jede der Werkstoffschichten 2 ist zwischen zwei der Elektrodenschichten 3, 4 angeordnet. Die Elektrodenschichten 3, 4 sind beidseitig bis an die jeweiligen Ränder des Stapels 1 geführt. Eine elektrische Kontaktierung erfolgt beispielhaft im Zusammenspiel auf gegenüberliegenden und geometrisch nicht zusammenhängenden Stapelumfangsbereichen 5, 6. Die Oberflächen der Stapelumfangsbereiche 5, 6, sind in der Regel geschliffen, um ebene Oberflächen für die weiteren Herstellungsschritte zu erhalten. Ein derartiger Stapel 1 ist aus dem Stand der Technik prinzipiell bekannt und dient beispielsweise als Piezoaktor für einen Piezoinjektor für einen Verbrennungsmotor.

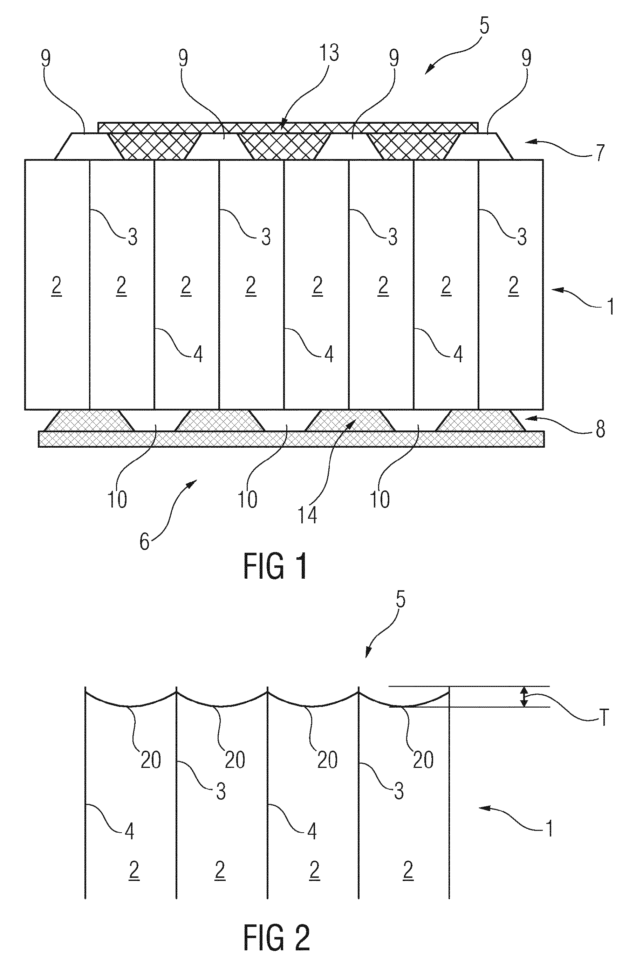

Wie der schematischen Querschnittsdarstellung der Fig. 1 zu entnehmen ist, ist auf dem Stapelumfangsbereich 5 eine Isolationsstruktur 7 aufgebracht. Die Isolationsstruktur 7 ist derart aufgebaut, dass die Elektrodenschichten 4 auf dem Stapelumfangsbereich 5 freigelegt sind. Zu diesem Zweck sind Isolationswälle 9 auf den Elektrodenschichten 3 aufgebracht. Lediglich beispielhaft erstrecken sich deren Flanken schräg in Richtung des Bauelementstapels 1. Die Flanken könnten auch senkrecht zu der Ebene des Stapelumfangsbereichs oder gewölbt, usw. ausgebildet sein.

In entsprechender Weise ist auf dem Stapelumfangsbereich 6 eine Isolationsstruktur 8 mit Isolationswällen 10 auf den Elektrodenschichten 4 vorgesehen. Flanken der Isolationswälle 10 erstrecken sich ebenfalls lediglich beispielhaft in Richtung des Bauelementstapels 1, wobei die Elektrodenschichten 3 freigelegt sind. Es versteht sich für einen Fachmann, dass auch die Flanken der Isolationswälle 10 von der gezeigten Form abweichen könnten.

Die Erzeugung der Isolationsstrukturen 7, 8 erfolgt z.B. durch ein subtraktives Verfahren. Hierbei wird zunächst eine zur elektrischen Isolation geeignete Schicht, z.B. aus einem Polymer oder einer Keramik oder einem temperaturstabilen Glas, flächig auf den jeweiligen Stapelumfangsbereich 5, 6 aufgebracht. Über ein Strukturierungsverfahren, wie z.B. Laserablation oder Fotostrukturierung, wird jede zweite der Elektrodenschichten 3, 4 auf einem jeweiligen Stapelumfangsbereich geöffnet. Wahlweise kann die Isolationsstruktur auch über ein Direktstrukturierungsverfahren, z.B. mittels Sprühen oder Dispensen, aufgebracht werden. Sofern das Material der Isolationsstruktur aus einem temperaturstabilen Glas gebildet wird, ist es zweckmäßig, wenn dieses eine verringerte Silbermigration aufweist. Hierdurch wird die Isolationseigenschaft des Glases für einen langen Zeitraum nicht negativ beeinflusst.

Die elektrische Kontaktierung der Elektrodenschichten 4 auf dem Stapelumfangsbereich 5 bzw. der Elektrodenschichten 3 auf dem Stapelumfangsbereich 6 wird durch eine Kontaktierungsstruktur realisiert, welche beispielsweise mittels eines Leitklebers realisiert werden kann. Bei einem Leitkleber sind in einem nicht-leitenden Material, wie z.B. einem Harz aus Polyimid oder Epoxyd, leitende Metallpartikel, eingebracht. Als Materialien kommen insbesondere Gold, Silber, Palladium, Platin, Kupfer oder Nickel sowie deren Legierungen in Betracht. Die Dicke der Kontaktierungsstruktur hängt von der zu erzielenden Stromtragfähigkeit der Kontaktierungsstruktur ab. Ebenso könnten die Kontaktierungsstrukturen auch aus einem Metall oder einer Metalllegierung gebildet sein.

Eine jeweilige Kontaktierungsstruktur 13, 14 übernimmt somit die elektrische Anbindung an die freigelegten Elektrodenschichten 3 bzw. 4 und dient zur Stromführung mit einer vorgegebenen Stromtragfähigkeit. Die Kontaktierungsstruktur 13, 14 bildet somit jeweilige Außenelektroden.

Da die Elektrodenschichten 4 nur wenige Mikrometer, typischerweise 1 bis 4 µm, dick sind, ist insbesondere bei der Verwendung eines Leitklebers als Material der Kontaktierungsstruktur die Gefahr gegeben, dass einzelne der Elektrodenschichten oder Abschnitte von Elektrodenschichten nicht ausreichend elektrisch an die Kontaktierungsstruktur angebunden sind. Hierdurch entsteht ein hoher Kontaktwiderstand, so dass es zu lokal überhöhten Stromdichten und erhöhten Temperaturen kommen kann.

Um die Anbindung des Materials der Kontaktierungsstruktur an die Elektrodenschichten zu verbessern, schlägt die Erfindung vor, vor dem Erzeugen der Kontaktierungsstruktur mittels eines materialabtragenden Verfahrens die Werkstoffschichten partiell derart abzutragen, dass die Elektrodenschichten oberflächennah freigelegt sind. Dies ist beispielsweise in Fig. 2 dargestellt, wobei die partielle Abtragung des Materials der Werkstoffschichten hier vor dem Aufbringen der Isolationsstruktur erfolgt.

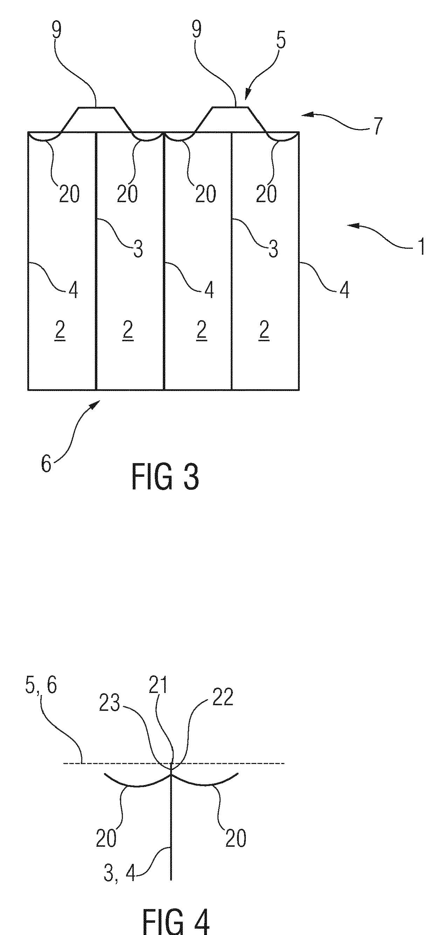

Das Abtragen des Materials der Werkstoffschichten kann beispielsweise mittels Schleifen, Bürsten, Strahlen oder durch einen Laser erfolgen. Werden die Stapelumfangsbereiche 5, 6 (wobei in Fig. 2 lediglich der Stapelumfangsbereich 5 dargestellt ist) mittels Sandstrahlen bearbeitet, so ergibt sich z.B. zwischen zwei benachbarten Elektrodenschichten eine konkave Gestalt der Oberflächen der Werkstoffschichten 2. Der in Fig. 2 dargestellte Schnitt verläuft hierbei parallel zu einer Längsachse des Stapels (welche sich in Fig. 2 in Blattebene von links nach rechts erstreckt) und senkrecht durch den Stapelumfangsbereich 5 (d.h. in Blattebene von oben nach unten). Durch das materialabtragende Verfahren werden oberflächennahe Abschnitte der Elektrodenschichten 3, 4 zusätzlich zu ihrer an den Stapelumfangsbereich 5, 6 grenzenden Stirnseite 21 zumindest teilweise an ihren gegenüberliegenden Hauptflächen 22, 23 freigelegt. Dies ist vergrößert und für lediglich zwei aneinander grenzende Werkstoffschichten 2 in Fig. 4 dargestellt.

Die Tiefe T des Materialabtrags des Materials der Werkstoffschichten 2 beträgt höchstens 10 µm bis 20 µm, ausgehend vom äußersten Ende einer Elektrodenschicht 3, 4 bis zum tiefsten Punkt der bearbeiteten Werkstoffschicht 2. Abhängig von dem gewählten Bearbeitungsverfahren wird sich hier im Bereich der Elektrodenschichten unter Umständen ein geringerer Materialabtrag als beispielsweise in der Mitte zwischen zwei Elektrodenschichten ergeben. Hierdurch bedingt werden lediglich einige Mikrometer im oberflächennahen Bereich der Elektrodenschichten vom Material der Werkstoffschicht 2 befreit. Diese freigelegten Kontaktflächen der Elektrodenschichten reichen jedoch aus, eine bessere elektrische Anbindung an das Material der Kontaktierungsstruktur bereitzustellen.

In Fig. 3 ist ein Ausschnitt eines Bauelementstapels 1 dargestellt, bei dem die Erzeugung des Materialabtrags 20 erst nach der Erzeugung der Isolationsstruktur 7 erfolgt. Das Freilegen der für die Kontaktierungsstruktur erforderlichen Bereiche in der Isolation 9 und das Erzeugen der Materialabtragungen 20 kann hierbei unter Verwendung des gleichen Bearbeitungsverfahrens erfolgen. Beispielsweise kann die Erzeugung der Gräben in der Isolationsstruktur 7 mit einem Laser erfolgen. Dieser kann weiter dazu verwendet werden, das Material der Werkstoffschicht 2 im Bereich zwischen zwei Wällen 9 abzutragen, so dass wiederum die konkaven Materialabtragungen entstehen.

In einer alternativen Ausgestaltung kann das Erzeugen der Gräben in der Isolationsstruktur 7 und das Erzeugen der Materialabtragungen 20 in den Werkstoffschichten 2 auch mit unterschiedlichen Bearbeitungsverfahren erfolgen.

Um die elektrische Anbindung der Kontaktierungsstruktur 13, 14 an die Elektrodenschichten 3, 4 weiter zu verbessern, kann ferner vorgesehen sein, auf die in den Figuren 2 und 3 erzeugten Oberflächenstrukturen eine dünne Metallschicht, insbesondere durch Sputtern, aufzubringen. Auf diese dünne Metallschicht wird dann in einem nachfolgenden Schritt die bereits beschriebene Kontaktierungsstruktur aufgebracht.

Aufgrund der geringen Tiefe der Materialabtragung 20 in den Werkstoffschichten ist nach dem Erzeugen der Isolationsstruktur und der Kontaktierungsstruktur dennoch sichergestellt, dass der fertig hergestellte Bauelementstapel eine ebene Oberfläche aufweist.

Das vorgeschlagene Vorgehen ist insbesondere in Verbindung mit der Verwendung von Leitkleber als Material der Kontaktierungsstruktur von Vorteil, da nach dem Aufbringen des Materials der Kontaktierungsstruktur sich die in dem Leitkleber enthaltenen Metallpartikel zufällig verteilen. Je größer jedoch die zur Verfügung stehende Kontaktfläche für die Metallpartikel ist, desto geringer ist die Gefahr, dass lokale Stellen mit hohem Kontaktwiderstand entstehen.

## Patentansprüche

1. Verfahren zum elektrischen Kontaktieren eines elektronischen Bauelements als Stapel (1), das aus einer Mehrzahl von auf Anlegen eines elektrischen Feldes reagierenden Werkstoffschichten (2) und einer Mehrzahl von Elektrodenschichten (3, 4) gebildet ist, wobei jede Werkstoffschicht (2) zwischen zwei der Elektrodenschichten (3, 4) angeordnet ist, bei dem
- auf zumindest einem Stapelumfangsbereich (5, 6) des Stapels (1) eine Isolationsstruktur (7, 8) erzeugt wird, wodurch jede zweite Elektrodenschicht (3, 4) des zumindest einen Stapelumfangsbereichs (5, 6) zur elektrischen Kontaktierung frei gelegt ist;
- auf den zumindest einen, mit der Isolationsstruktur (7, 8) versehenen Stapelumfangsbereich (5, 6) eine Kontaktierungsstruktur (13, 14) aufgebracht wird;
wobei
- vor dem Schritt des Erzeugens der Kontaktierungsstruktur (13, 14) mittels eines materialabtragenden Verfahrens lediglich das Material der Werkstoffschichten (2) ohne Abtrag des Materials der Elektrodenschichten partiell derart abgetragen wird, dass zumindest jede zweite Elektrodenschicht (3, 4) oberflächennah freigelegt wird und dass die Werkstoffschichten (2) in einem Schnitt, der parallel zu einer Längsachse des Stapels (1) und senkrecht durch einen der Stapelumfangsbereiche (5, 6) verläuft, zwischen zwei benachbarten Elektrodenschichten (3, 4) eine konkave Gestalt aufweisen, wobei sich im Bereich der Elektrodenschichten (3, 4) ein geringerer Materialabtrag (20)
des Materials der Werkstoffschichten (2) ergibt als in der Mitte zwischen den beiden Elektrodenschichten (3, 4).

2. Verfahren nach Anspruch 1,
**dadurch gekennzeichnet, dass**
das Abtragen des Materials der Werkstoffschichten (2) derart erfolgt, dass oberflächennahe Abschnitte der Elektrodenschichten (3, 4) zusätzlich zu ihrer an den Stapelumfangsbereich (5, 6) grenzenden Stirnseite zumindest teilweise an ihren Hauptflächen freigelegt werden.

3. Verfahren nach Anspruch 1 oder 2,
**dadurch gekennzeichnet, dass**
das partielle, oberflächennahe Abtragen des Materials der Werkstoffschichten (2) vor dem Schritt des Erzeugens der Isolationsstruktur erfolgt.

4. Verfahren nach Anspruch 1 oder 2,
**dadurch gekennzeichnet, dass**
das partielle, oberflächennahe Abtragen des Materials der Werkstoffschichten (2) nach dem Schritt des Erzeugens der Isolationsstruktur erfolgt.

5. Verfahren nach Anspruch 4,
**dadurch gekennzeichnet, dass**
gleichzeitig mit dem Freilegen jeder zweiten Elektrodenschicht (3, 4) des zumindest einen Stapelumfangsbereichs (5, 6) zur elektrischen Kontaktierung das Abtragen des Materials der Werkstoffschichten (2) in den freigelegten Bereichen erfolgt.

6. Verfahren nach Anspruch 4 oder 5,
**dadurch gekennzeichnet, dass**
das Freilegen jeder zweiten Elektrodenschicht (3, 4) und das Abtragen des Materials der Werkstoffschichten (2) durch das gleiche Bearbeitungsverfahren erfolgt.

7. Verfahren nach einem der vorhergehenden Ansprüche,
**dadurch gekennzeichnet, dass**
das partielle, oberflächennahe Abtragen des Materials der Werkstoffschichten (2) mittels Schleifen, Bürsten, Strahlen oder durch einen Laser erfolgt.

8. Verfahren nach einem der vorhergehenden Ansprüche,
**dadurch gekennzeichnet, dass**
nach dem Schritt des Erzeugens der Isolationsstruktur (7, 8) und dem gegebenenfalls darauffolgenden Schritt des partiellen Abtragens des Materials der Werkstoffschichten (2), eine dünne Metallschicht, insbesondere durch Sputtern, auf den Stapelumfangsbereich (7, 8) aufgebracht wird, auf welche in einem nachfolgenden Schritt die Kontaktierungsstruktur (13, 14) auf die dünne Metallschicht aufgebracht wird.

9. Als Stapel (1) ausgebildetes elektronisches Bauelement, umfassend:
- eine Mehrzahl von Elektrodenschichten (3, 4);
- eine Mehrzahl von auf Anlegen eines elektrischen Feldes reagierenden Werkstoffschichten (2), wobei jede Werkstoffschicht (2) zwischen zwei der Elektrodenschichten (3, 4) angeordnet ist;
- eine Isolationsstruktur (7, 8), die auf zumindest einem Stapelumfangsbereich (5, 6) des Stapels (1) aufgebracht ist, wobei die Isolationsstruktur (7) derart ausgebildet ist, dass jede zweite Elektrodenschicht (3, 4) eines Stapelumfangsbereichs (5, 6) zur elektrischen Kontaktierung frei gelegt ist;
- einer auf den zumindest einen, mit der Isolationsstruktur (7, 8) versehenen Stapelumfangsbereich (5, 6) aufgebrachten Kontaktierungsstruktur (13, 14);
wobei
- die Werkstoffschichten (2) in einem Schnitt, der parallel zu einer Längsachse des Stapels (1) und senkrecht durch einen der Stapelumfangsbereiche (5, 6) verläuft, zumindest in einem oberflächennahen Bereich, der an die freigelegten Elektrodenschichten (3, 4) angrenzt, zumindest teilweise derart abgetragen sind, dass die Elektrodenschichten sowohl an ihrer an den Stapelumfangsbereich grenzenden Stirnseite als auch zumindest teilweise an ihren sich gegenüberliegenden Hauptflächen freigelegt sind, und durch Material der Isolationsstruktur (7, 8) oder der Kontaktierungsstruktur (13, 14) ersetzt sind
- die Werkstoffschichten (2) in dem Schnitt, der parallel zu einer Längsachse des Stapels (1) und senkrecht durch einen der Stapelumfangsbereiche (5, 6) verläuft, zwischen zwei benachbarten Elektrodenschichten (3, 4) eine konkave Gestalt aufweisen,
**dadurch gekennzeichnet, dass** im Bereich der Elektrodenschichten (3, 4) ein geringerer Materialabtrag (20) des Materials der Werkstoffschichten (2) vorhanden ist als in der Mitte zwischen den beiden Elektrodenschichten (3, 4).

10. Stapel nach Anspruch 9,
**dadurch gekennzeichnet, dass**
die Werkstoffschichten (2) gegenüber dem Stapelumfangsbereich (5, 6) bereichsweise um höchstens 10µm bis 20µm reduziert sind.

11. Stapel nach einem der Ansprüche 9 oder 10,
**dadurch gekennzeichnet, dass**
das Material der Kontaktierungsstruktur (13, 14) einen Leitkleber mit einem Träger aus einem nicht leitenden Material, insbesondere Polyimid, und darin eingebetteten Metallpartikeln umfasst.

## Claims

1. Method for making electrical contact with an electronic component in the form of a stack (1) which is formed from a plurality of material layers (2) that react upon application of an electric field, and a plurality of electrode layers (3, 4), wherein each material layer (2) is arranged between two of the electrode layers (3, 4), in which
- an insulation structure (7, 8) is produced on at least one stack circumferential region (5, 6) of the stack (1), with the result that every second electrode layer (3, 4) of the at least one stack circumferential region (5, 6) is exposed for electrical contact to be made;
- a contact-making structure (13, 14) is applied to the at least one stack circumferential region (5, 6) that is provided with the insulation structure (7, 8);
wherein
- before the step of producing the contact-making structure (13, 14), only the material of the material layers (2) is partially removed, without removal of the material of the electrode layers, by means of a material-removing method in such a way that at least every second electrode layer (3, 4) is exposed close to the surface and that the material layers (2) have a concave form, in a section which extends parallel to a longitudinal axis of the stack (1) and perpendicularly through one of the stack circumferential regions (5, 6), between two adjacent electrode layers (3, 4), wherein a lesser material removal (20) of the material of the material layers (2) results in the region of the electrode layers (3, 4) than in the middle between the two electrode layers (3, 4).

2. Method according to Claim 1,
**characterized in that**
the removal of the material of the material layers (2) takes place such that sections, close to the surface, of the electrode layers (3, 4) are at least partially exposed at their main surfaces in addition to their end sides adjoining the stack circumferential region (5, 6).

3. Method according to Claim 1 or 2,
**characterized in that**
the partial removal, close to the surface, of the material of the material layers (2) takes place before the step of producing the insulation structure.

4. Method according to Claim 1 or 2,
**characterized in that**
the partial removal, close to the surface, of the material of the material layers (2) takes place after the step of producing the insulation structure.

5. Method according to Claim 4,
**characterized in that**
at the same time as the exposure of every second electrode layer (3, 4) of the at least one stack circumferential region (5, 6) for making electrical contact, the removal of the material of the material layers (2) in the exposed regions takes place.

6. Method according to Claim 4 or 5,
**characterized in that**
the exposure of every second electrode layer (3, 4) and the removal of the material of the material layers (2) take place by way of the same machining method.

7. Method according to one of the preceding claims,
**characterized in that**
the partial removal, close to the surface, of the material of the material layers (2) takes place by means of grinding, brushing, blasting or by way of a laser.

8. Method according to one of the preceding claims,
**characterized in that**
after the step of producing the insulation structure (7, 8) and the optionally following step of partially removing the material of the material layers (2), a thin metal layer is applied to the stack circumferential region (7, 8), in particular by sputtering, the contact-making structure (13, 14) being applied to said thin metal layer in a subsequent step.

9. Electronic component in the form of a stack (1), comprising:
- a plurality of electrode layers (3, 4);
- a plurality of material layers (2) that react upon application of an electric field, wherein each material layer (2) is arranged between two of the electrode layers (3, 4) ;
- an insulation structure (7, 8) which has been applied to at least one stack circumferential region (5, 6) of the stack (1), wherein the insulation layer (7) has been formed such that every second electrode layer (3, 4) of a stack circumferential region (5, 6) is exposed for electrical contact to be made;
- a contact-making structure (13, 14) applied to the at least one stack circumferential region (5, 6) provided with the insulation structure (7, 8);
wherein
- the material layers (2) have been at least partially removed in such a way that the electrode layers are exposed both at their end sides adjoining the stack circumferential region and at least partially at their opposite main surfaces, and replaced by material of the insulation structure (7, 8) or of the contact-making structure (13, 14) in a section which extends parallel to a longitudinal axis of the stack (1) and perpendicularly through one of the stack circumferential regions (5, 6), at least in a region, close to the surface, which adjoins the exposed electrode layers (3, 4),
- the material layers (2) have a concave form in the section which extends parallel to a longitudinal axis of the stack (1) and perpendicularly through one of the stack circumferential regions (5, 6) between two adjacent electrode layers (3, 4), **characterized in that** there is a lesser material removal (20) of the material of the material layers (2) in the region of the electrode layers (3, 4) than in the middle between the two electrode layers (3, 4).

10. Stack according to Claim 9,
**characterized in that**
the material layers (2) have been reduced regionally by at most 10 µm to 20 µm with respect to the stack circumferential region (5, 6).

11. Stack according to either of Claims 9 and 10,
**characterized in that**
the material of the contact-making structure (13, 14) comprises a conductive adhesive having a backing made of a nonconductive material,
in particular polyimide, and metal particles embedded therein.

## Revendications

1. Procédé pour la mise en contact électrique d'un module électronique sous forme d'empilement (1), qui est constitué d'une pluralité de couches de matériau (2) réagissant à l'application d'un champ électrique et d'une pluralité de couches d'électrodes (3, 4), chaque couche de matériau (2) étant disposée entre deux couches d'électrodes (3, 4), dans lequel procédé
- sur au moins une zone périphérique (5, 6) de l'empilement (1) est générée une structure d'isolation (7, 8), moyennant quoi chaque deuxième couche d'électrodes (3, 4) de ladite au moins une zone périphérique (5, 6) de l'empilement est mise à nu pour la mise en contact électrique ;
- une structure de mise en contact (13, 14) est déposée sur ladite au moins une zone périphérique (5, 6) de l'empilement munie de la structure d'isolation (7, 8) ;
dans lequel
- avant l'étape de la réalisation de la structure de mise en contact (13, 14), seul le matériau des couches de matériau (2) est enlevé partiellement au moyen d'un procédé par enlèvement de matière sans que les couches d'électrodes subissent un enlèvement de matière, de telle sorte qu'au moins chaque deuxième couche d'électrodes (3, 4) est mise à nu à proximité de la surface et de telle sorte que, sur une coupe qui s'étend parallèlement à un axe longitudinal de l'empilement (1) et perpendiculairement à travers l'une des zones périphériques (5, 6) de l'empilement, les couches de matériau (2) comportent une forme concave entre deux couches d'électrodes (3, 4) adjacentes, l'enlèvement de matière (20) dans les couches de matériau (2) étant plus faible dans la zone des couches d'électrodes (3, 4) qu'au milieu entre les deux couches d'électrodes (3, 4).

2. Procédé selon la revendication 1, **caractérisé en ce que** l'enlèvement de matière dans les couches de matériau (2) est effectué de telle sorte que des parties proches de la surface dans les couches d'électrodes (3, 4) sont mises à nu, en plus de leurs faces frontales jouxtant la zone périphérique (5, 6) de l'empilement, au moins partiellement dans leurs surfaces principales.

3. Procédé selon la revendication 1 ou 2, **caractérisé en ce que** l'enlèvement de matière partiel, proche de la surface, dans les couches de matériau (2) est effectué avant l'étape de la réalisation de la structure d'isolation.

4. Procédé selon la revendication 1 ou 2, **caractérisé en ce que** l'enlèvement de matière partiel, proche de la surface, dans les couches de matériau (2) est effectué après l'étape de la réalisation de la structure d'isolation.

5. Procédé selon la revendication 4, **caractérisé en ce que** la mise à nu de chaque deuxième couche d'électrodes (3, 4) de ladite au moins une zone périphérique (5, 6) de l'empilement en vue de la mise en contact électrique est effectuée en même temps que l'enlèvement de matière dans les couches de matériau (2) dans les zones mises à nu.

6. Procédé selon la revendication 4 ou 5, **caractérisé en ce que** la mise à nu de chaque deuxième couche d'électrodes (3, 4) et l'enlèvement de matière dans les couches de matériau (2) sont effectués par le même procédé d'usinage.

7. Siège de véhicule selon l'une quelconque des revendications précédentes, **caractérisé en ce que** l'enlèvement de matière partiel, proche de la surface, dans les couches de matériau (2) est effectué par meulage, décapage, rayonnement ou par un laser.

8. Procédé selon l'une quelconque des revendications précédentes, **caractérisé en ce que**, après l'étape de la réalisation de la structure d'isolation (7, 8) et l'étape, éventuellement consécutive, de l'enlèvement de matière partiel dans les couches de matériau (2), une mince couche métallique est déposée, en particulier par pulvérisation cathodique, sur la zone périphérique (5, 6) de l'empilement, sur laquelle la structure de mise en contact (13, 14) est déposée sur la mince couche métallique au cours d'une étape consécutive.

9. Module électronique réalisé sous la forme d'un empilement (1), comportent :
- une pluralité de couches d'électrodes (3, 4) ;
- une pluralité de couches de matériau (2) réagissant à l'application d'un champ électrique, chaque couche de matériau (2) étant disposée entre deux couches d'électrodes (3, 4) ;
- une structure d'isolation (7, 8) qui est déposée sur au moins une zone périphérique (5, 6) de l'empilement (1), la structure d'isolation (7) étant réalisée de telle sorte que chaque deuxième couche d'électrodes (3, 4) d'une zone périphérique (5, 6) de l'empilement est mise à nu pour la mise en contact électrique ;
- une structure de mise en contact (13, 14) déposée sur ladite au moins une zone périphérique (5, 6) de l'empilement munie de la structure d'isolation (7, 8) ;
dans lequel
- sur une coupe qui s'étend parallèlement à un axe longitudinal de l'empilement (1) et perpendiculairement à travers l'une des zones périphériques (5, 6) de l'empilement, les couches de matériau (2), au moins dans une zone proche de la surface qui jouxte les couches d'électrodes (3, 4) mises à nu, subissent au moins partiellement un enlèvement de matière, de telle sorte que les couches d'électrodes sont mises à nu tant sur leur face frontale jouxtant la zone périphérique de l'empilement que, au moins partiellement, sur leurs surfaces principales opposées, et sont remplacées par la matière de la structure d'isolation (7, 8) ou de la structure de mise en contact (13, 14),
- sur la coupe qui s'étend parallèlement à un axe longitudinal de l'empilement (1) et perpendiculairement à travers l'une des zones périphériques (5, 6) de l'empilement, les couches de matériau (2) ont une forme concave entre deux couches d'électrodes (3, 4) adjacentes, **caractérisé en ce que** l'enlèvement de matière (20) dans les couches de matériau (2) est plus faible dans la zone des couches d'électrodes (3, 4) qu'au milieu entre les deux couches d'électrodes (3, 4).

10. Empilement selon la revendication 9, **caractérisé en ce que**
les couches de matériau (2) en vis-à-vis la zone périphérique (5, 6) de l'empilement sont diminuées par zones de 10 µm à 20 µm au maximum.

11. Empilement selon la revendication 9 ou 10, **caractérisé en ce que** le matériau de la structure de mise en contact (13, 14) comporte une colle conductrice avec un support dans un matériau non conducteur, en particulier un polyimide, et des particules métalliques enrobées dans celui-ci.
